# EUROPÄISCHE PATENTSCHRIFT

(11) **EP 2 145 862 B1**
(45) Veröffentlichungstag und Bekanntmachung des Hinweises auf die Patenterteilung: **16.02.2011**
(21) Anmeldenummer: 09164993.9
(22) Anmeldetag: 09.07.2009
(51) Int. Cl.: C03B 19/09, C03B 20/00, C30B 15/10

(54) **Verfahren zur Herstellung eines Quarzglastiegels**
Method for producing a quartz glass crucible
Procédé de fabrication d'un creuset de verre en quartz

(30) Priorität: 19.07.2008 DE 102008033946
(43) Veröffentlichungstag der Anmeldung: 20.01.2010
(73) Patentinhaber: Heraeus Quarzglas GmbH & Co. KG, 63450 Hanau (DE)
(72) Erfinder: Trommer, Martin, 06749 Bitterfeld-Wolfen (DE); Kayser, Thomas, 04105 Leipzig (DE)
(74) Vertreter: Staudt, Armin Walter

(56) Entgegenhaltungen:
- EP-A- 1 026 289
- DE-A1-102006 043 738
- US-B1- 6 381 986
- LEVIT L G ET AL: "PREPARATION OF SILICA GLASS DOPED WITH NITROGEN BY MODIFIED CHEMICAL VAPOR DEPOSITION" GLASS PHYSICS AND CHEMISTRY, INTERPERIODICA PUBLISHING, BIRMINGHAM, AL, US, Bd. 26, Nr. 5, 1. September 2000 (2000-09-01), Seiten 506-509, XP000969983 ISSN: 0360-5043

## Beschreibung

Die Erfindung betrifft ein Verfahren zur Herstellung eines Quarzglastiegels mit einer Tiegelwandung, die stickstoffdotiertes Quarzglas enthält, indem an einer Innenseite einer Schmelzform eine poröse SiO₂Schicht aus SiO₂-Teilchen ausgeformt und zu einer Stabilisierungsschicht aus Quarzglas mit darin chemisch gebundenem Stickstoff verglast wird, wobei die SiO₂-Teilchen vor oder während des Verglasens unter Einsatz eines Stickstoff enthaltenden Reaktionsgases nitridiert werden.

### Stand der Technik

Quarzglastiegel werden beispielsweise als Kokillen beim Erschmelzen von Solarsilizium eingesetzt oder zur Aufnahme von Metallschmelze beim Ziehen von Einkristallen nach dem sogenannten Czochralski-Verfahren. Im Zuge der immer gröβer werdenden Siliziumkristalle und der damit einhergehenden Verlängerung der Prozessdauer spielt die thermische Stabilität des Quarzglastiegels eine wichtige Rolle. Für den unteren Erweichungspunkt für Quarzglas werden in der Literatur Temperaturwerte um 1150 °C angegeben. Häufig liegen die erforderlichen Prozesstemperaturen jedoch höher, so dass es zu plastischen Verformungen des Quarzglastiegels kommen kann. Die Schmelztemperatur von Silizium beträgt beispielsweise etwa 1420 °C. Darüber hinaus unterliegt der Quarzglastiegel bei seinem bestimmungsgemäßen Einsatz über mehrere Stunden auch hohen korrosiven Belastungen.

Daher liegt von jeher auf der Verbesserung der thermischen und chemischen Stabilität von Quarzglastiegeln ein besonders Augenmerk, und eine Vielzahl von Maßnahmen dafür sind vorgeschlagen worden. In der DE 101 39 648 B4 wird ein oberflächennahes Auskristallisieren der Tiegelwandung unter Ausbildung von Cristobalit empfohlen, dessen Schmelzpunkt bei etwa 1720 °C liegt. Die DE 101 14 698 A1 lehrt ein Beschichten der Oberfläche mit einer Oberflächenschicht aus einem feuerfesten Werkstoff durch thermisches Spritzen und die DE 197 10 672 C2 eine Beladung des Quarzglases mit viskositätserhöhenden Dotierstoffen, wie etwa Aluminiumoxid.

Es werden auch Quarzglastiegel verwendet, die eine dünne Siliziumnitridschicht auf ihrer Innenwandung aufweisen. Diese Schicht wird entweder durch Abscheidung von Si₃N₄ aus der Gasphase oder durch Aufbringen von Siliziumnitrid-Pulver in Form einer Suspension hergestellt. Ein derartiger Tiegel ist beispielsweise in der JP 2002-226291 A beschrieben. Die Siliziumnitridschicht ist im Wandbereich zwischen 0,15 bis 5 µm dick und im Bodenbereich ist sie etwas dünner. Sie ist insbesondere bei Quarzglastiegeln zum Einschmelzen von Solarsilizium zur Verbesserung der Korrosionsbeständigkeit vorgesehen. Wegen des hohen Schmelzpunktes schmelzen allerdings Si₃N₄-Fragmente der Beschichtung in der Siliziumschmelze nicht mehr auf und können so zu Störungen im Siliziumkristall führen. Aus diesem Grund ist eine Si₃N₄-Beschichtung beim Czochralski-Verfahren, bei dem es auf eine hohe Versetzungsfreiheit des Silizium-Einkristalls ankommt, unüblich.

Ein Quarzglastiegel und ein Verfahren für seine Herstellung sind aus der US 6,381,986 B1 bekannt. Zur Verbesserung der Wärmebeständigkeit des Tiegels ist hier eine Dotierung des Quarzglases mit Stickstoff vorgesehen. Die Herstellung des Quarzglastiegels erfolgt über ein Schlickergießverfahren. Dabei wird ein SiO₂Schlicker zu einem porösen Grünkörper geformt, dieser getrocknet und vor dem Verglasen bei einer Temperatur im Bereich von 850 °C bis 1200°C in einer Ammoniak enthaltenden Atmosphäre behandelt. Auf diese Weise wird eine chemische Bindung des Stickstoffs im Quarzglasnetzwerk erreicht, die zu einer höheren Wärmebeständigkeit führt.

Beim Einsatz von Ammoniak zur Erzeugung der Stickstoff-Beladung des Quarzglases bildet sich bei einer Zersetzung des Ammoniaks gleichzeitig Wasserstoff, der zu reduzierenden Schmelzbedingungen und zu einem merklichen Einbau von Hydroxylgruppen in das Quarzglas führt, was mit einer Abnahme der Viskosität des Quarzglases einhergeht.

Der Gesamt-Stickstoffgehalt des Quarzglases setzt sich aus einem Anteil an physikalisch gelöstem Stickstoff und einem Anteil an chemisch im Netzwerk des Quarzglases fest gebundenem Stickstoff zusammen. Der nur physikalisch gelöste Stickstoff wird beim Aufheizen des dotierten Quarzglastiegels bei relativ niedrigen Temperaturen freigesetzt und führt zu einer Blasenbildung und damit zu einer Erodierung der Tiegelwandung.

### Aufgabenstellung

Der Erfindung liegt daher die Aufgabe zugrunde, ein Verfahren anzugeben, mittels dem in der Wandung eines Quarzglastiegels eine Stickstoffdotierung mit einem möglichst hohen Anteil an chemisch gebundenem Stickstoff erreichbar ist.

Hinsichtlich des Verfahrens wird diese Aufgabe ausgehend von dem Verfahren der eingangs genannten Gattung erfindungsgemäß dadurch gelöst, dass als stickstoffhaltiges Reaktionsgas ein Stickoxid eingesetzt wird.

Der Stickstoff wird in das Quarzglas der SiO₂-Teilchen über die Gasphase eingebracht und zwar durch Einsatz von einem Stickoxid oder mehrerer Stickoxide. Als Stickoxid kommen beispielsweise N₂O, NO und NO₂ in Betracht. Die Konzentration des Stickoxids liegt in der Regel deutlich niedriger als 100 %, andere Gase der Atmosphäre sind zum Beispiel Stickstoff, Edelgas oder Sauerstoff oder Ammoniak. Bei der thermischen Zersetzung von Stickoxiden entstehen reaktive Stickstoffatome, die bereits bei niedrigen Temperaturen (< 1.200 °C) mit dem Quarzglas-Netzwerk unter Bildung von Si-N, Si-ON, Si-NH-Bindungen und anderer Stickstoff-Verbindungen reagieren. Diese Reaktion führt zu einer festen chemischen Einbindung des Stickstoffs in das Quarzglas-Netzwerk.

Die SiO₂-Teilchen bilden beim Herstellungsprozess des Quarzglastiegels eine poröse SiO₂-Körnungsschicht. Die Stickstoff-Beladung des Quarzglases der SiO₂-Teilchen erfolgt vor und/oder beim Verglasen dieser SiO₂-Körnungsschicht. In jedem Fall bleibt die chemische Bindung des Stickstoffs auch nach dem vollständigen Verglasen der Körnungsschicht erhalten, so dass eine Stabilisierungsschicht erzeugt wird, die aus Quarzglas mit darin chemisch gebundenem Stickstoff besteht.

Die Stabilisierungsschicht erstreckt sich über die gesamte Dicke der Tiegelwandung oder nur über einen Teil davon. Sie ist in allen Bereichen des Tiegels vorgesehen, wie etwa einem Seitenbereich, einem Bodenbereich und einem Übergangsbereich zwischen Seiten- und Bodenbereich oder nur in den besonders belasteten Bereichen.

Die Beladung (Dotierung) der SiO₂-Teilchen mit Stickstoff erfolgt unmittelbar bei ihrer Herstellung und/oder danach. Im Fall einer (ergänzenden) nachträglichen Beladung liegen die SiO₂-Teilchen in loser Schüttung oder als mechanisch oder thermisch geringfügig vorverdichtete Körnungsschicht vor.

Die erfindungsgemäße Art der Stickstoffdotierung der Stabilisierungsschicht resultiert in einem hohen Anteil an chemisch gebundenem Stickstoff im Bereich zwischen 1 Gew.-ppm und 150 Gew.-ppm, der eine Erhöhung der Viskosität des Quarzglases bewirkt und damit zu einer höheren thermischen Beständigkeit und einer längeren Standzeit des Quarzglastiegels beiträgt.

Bei Stickstoffgehalten im ppb-Bereich macht sich die positive Wirkung des Stickstoffes nicht wesentlich bemerkbar und bei Stickstoffgehalten oberhalb von 60 Gew.-ppm besteht die Tendenz zu einer Blasenbildung, die sich bei mehr als 150 Gew.-ppm besonders bemerkbar macht.

Im Hinblick hierauf hat es sich als besonders vorteilhaft erwiesen, wenn der Stickstoffgehalt des Quarzglases im Bereich zwischen 10 und 100 Gew.-ppm liegt, und vorzugsweise mindestens 30 Gew.-ppm beträgt.

Die Messung des Stickstoffgehalts erfolgt mittels eines Gasanalyseverfahrens, das als "Trägerheißgasextraktion" bekannt ist. Dabei wird eine genau eingewogene Probemenge in einem Graphit-Tiegel sehr hoch erhitzt und das dabei frei gesetzte Stickstoffgas anhand der Wärmeleitfähigkeit der Messzellen erfasst. Für Stickstoff liegt die Nachweisbarkeitsgrenze dieser Methode unter 1 Gew.-ppm.

Als stickstoffhaltiges Reaktionsgas hat sich Distickstoffmonoxid als besonders geeignet erwiesen.

Distickstoffmonoxid (N₂O; Lachgas) ist in geringen Mengen gesundheitlich nahezu unbedenklich. Es zersetzt sich bei einer Temperatur um 650 °C und setzt dabei reaktiven Stickstoff frei, der mit der Netzwerkstruktur des Quarzglases reagieren kann.

Bei einer besonders bevorzugten Verfahrensvariante ist vorgesehen, dass SiO₂-Teilchen eingesetzt werden, die vor dem Nitridieren eine Konzentration an Sauerstoffmangeldefekten von mindestens 2 x 10¹⁵ cm⁻³ aufweisen.

Die Netzwerkstruktur von Quarzglas kann eine Vielzahl von Defekten aufweisen. Eine Gruppe solcher Defekte sind Sauerstoffmangeldefekte, bei denen Sauerstoffstellen des Netzwerks nicht besetzt sind. Bekannte Beispiele dafür sind direkte -Si-Si-Bindungen (163 nm und 243 nm) und ein nur zweifach koordiniertes Siliziumatom (247 nm), wobei in Klammern die Absorptionswellenlänge derjeweiligen Defektstelle angegeben ist. Es hat sich gezeigt, dass reaktive Stickstoffatome, wie sie sich aufgrund der Zersetzung des Stickoxids bilden, mit vorhandenen Fehlstellen der Quarzglas-Netzwerkstruktur und insbesondere mit Sauerstoffmangeldefekten besonders leicht reagieren können. Im Fall von Sauerstoffmangeldefekten werden die vakanten Sauerstoffstellen durch Stickstoff besetzt, so dass sich stabile Si-N-Bindungen bilden. Auf diese Weise gelingt eine besonders hohe Beladung des Quarzglases mit chemisch gebundenem Stickstoff.

Die Konzentration an Sauerstoffmangeldefekten in Quarzglas wird indirekt durch den Transmissionsverlust ermittelt. Der Transmissionsverlust beruht dabei auf der Aufspaltung der Sauerstoff-Fehlstellen unter Laserbestrahlung in jeweils zwei so genannte E'-Zentren, die eine charakteristische Absorption bei einer Wellenlänge von 210 nm zeigen.

Bei SiO₂-Teilchen aus synthetischem Quarzglas können die Sauerstoffmangeldefekte bereits bei der Herstellung der SiO₂-Teilchen erzeugt werden. Alternativ oder ergänzend dazu hat es sich auch bewährt, die Sauerstoffmangeldefekte durch eine Temperaturbehandlung der SiO₂-Teilchen bei einer Temperatur oberhalb von 500 °C in reduzierend wirkender Atmosphäre einzustellen.

Weiterhin hat es sich als günstig erweisen, wenn SiO₂-Teilchen eingesetzt werden, die eine mittlere Teilchengröße im Bereich von 30 µm bis 300 µm aufweisen (jeweils D₅₀-Wert).

Dabei handelt es sich um relativ feinteilige Körnung mit großer spezifischer Oberfläche, die sowohl im Hinblick auf eine nachträgliche Erzeugung von Defektstellen als auch hinsichtlich der auf Diffusionsprozessen beruhenden Beladung der SiO₂-Teilchen mit Stickstoff wegen der kurzen Diffusionswege vorteilhaft ist. Im Hinblick auf eine möglichst hohe Beladung mit Stickstoff haben sich SiO₂-Teilchen mit einem mittleren Teilchendurchmesser von weniger als 100 µm besonders bewährt. Dabei wird angenommen, dass der Mechanismus der Stickstoff-Beladung über die Besetzung von Sauerstoffmangeldefekten nur in oberflächennahen Bereichen der SiO₂-Teilchen wirksam ist.

Bei einer besonders bevorzugten Variante des erfindungsgemäßen Verfahrens ist vorgesehen, dass die SiO₂-Teilchen vor der Ausformung der porösen SiO₂-Schicht nitridiert werden.

Hierbei wird die poröse Körnungsschicht aus SiO₂-Teilchen ausgebildet, die vorab mit Stickstoff beladen worden sind. Die Stickstoff-Beladung der SiO₂-Teilchen erfolgt entweder bei der Teilchenherstellung, wobei insbesondere das Beladen beim Verglasen von SiO₂-Granulatkörnern aus Agglomeraten von SiO₂-Nanoteilchen in einer das Stickoxid enthaltenden Atmosphäre in Betracht kommt. Oder die Stickstoff-Beladung der SiO₂-Teilchen erfolgt in einer losen Schüttung der verglasten Teilchen in einer das Stickoxid enthaltenden Atmosphäre. Dabei ist zu gewährleisten, dass die SiO₂-Teilchen in möglichst feinteiliger Form vorliegen (mittlerer Durchmesser < 100 µm), da andernfalls eine nennenswerte Beladung mit Stickstoff kaum möglich ist. Ein Vorteil dieser Verfahrensweise liegt darin, dass in den SiO₂-Teilchen vor ihrem Einsatz ein definierter und überprüfbarer Stickstoffgehalt ohne die beschränkenden Randbedingungen der Tiegelherstellung einstellbar ist. Dies verbessert die Reproduzierbarkeit des Verfahrens. Durch eine zusätzliche Nitridierung während der Tiegelherstellung, insbesondere während des Verglasens der porösen SiO₂-Schicht, können etwaige Verluste an Stickstoff kompensiert oder vermieden oder die Stickstoffkonzentration in den SiO₂-Teilchen erhöht werden.

In dem Zusammenhang hat es sich als günstig erweisen, wenn die Nitridierung bei einer Behandlungstemperatur unterhalb von 1.100 °C, vorzugsweise im Temperaturbereich zwischen 650 und 1.000 °C erfolgt.

Die Temperatur während der Nitridierungsbehandlung der SiO₂-Teilchen ist so gewählt, dass einerseits die Aktivierungsenergie für die thermischen Zersetzung des Stickoxids bereitsteht, und andererseits eine Agglomeration der SiO₂-Teilchen oder die Ausbildung einer die weitere Diffusion des Stickoxids hemmenden glasigen Schicht vermieden wird. So wird sichergestellt, dass die gasförmigen Behandlungsreagenzien die Anhäufung der SiO₂-Teilchen durchdringen und gleichmäßig mit dem Quarzglas-Netzwerk reagieren können. Dies führt zu einer gleichmäßigen Verteilung des Stickoxids in einer Aufschüttung der SiO₂-Teilchen, beziehungsweise in einer aus den Teilchen geformten, porösen Körnungsschicht beim Tiegelherstellungsprozess, was zu einer homogenen Stickstoff-Beladung der SiO₂-Teilchen beiträgt.

Es hat sich als günstig erweisen, wenn der Stickoxidgehalt der Atmosphäre während der Nitridierung mindestens zeitweise zwischen 2 und 50 Vol.-%, vorzugsweise zwischen 5 und 20 Vol.-% beträgt.

Bei Stickoxidgehalten unterhalb von 2 Vol.-% ergibt sich eine geringe Stickstoff-Beladung und eine geringe viskositätssteigernde Wirkung, und bei Stickoxidgehalten oberhalb von 50 Vol.-% kann es zu einer Überbeladung mit Stickstoff und einer Blasenbildung bei nachfolgenden Hochtemperaturprozessen kommen. In Fällen, in denen es wesentlich auf die Absättigung der Sauerstoffdefizitstellen und weniger auf eine hohe Stickstoffbeladung ankommt, genügt ein deutlich niedrigerer Stickoxidgehalt in der Nitridierungs-Atmosphäre (zum Beispiel 0,5 Gew.-ppm).

Im Hinblick auf eine Stickstoff-Beladung in kürzerer Zeit ist es vorteilhaft, wenn die Nitridierung unter einem Überdruck des Stickstoff enthaltenden Reaktionsgases erfolgt.

Die Stabilisierungsschicht wird vorzugsweise mit einer Dicke im Bereich von 1 bis 30 mm, besonders bevorzugt mit einer Dicke im Bereich von 2 bis 15 mm, erzeugt.

Eine Dicke von weniger als 1 mm wirkt sich auf die thermische Stabilität des Quarzglastiegels nicht nennenswert aus. Bei einer Dicke von mehr als 30 mm steht dem zusätzlichen Aufwand zur Erzeugung der Stabilisierungsschicht kein adäquater Zugewinn an thermischer Stabilität gegenüber.

Weiterhin hat es sich bewährt, wenn die Stabilisierungsschicht in einem Bereich der Tiegelwandung erzeugt wird, der beim bestimmungsgemäßen Einsatz mit einer im Tiegel enthaltenen Schmelze nicht in Kontakt kommt.

Wegen der Stickstoff-Beladung der Stabilisierungsschicht kann es beim bestimmungsgemäßen Einsatz des Quarzglastiegels zu einem Eintrag von Stickstoff in die Metallschmelze kommen, wenn die Stabilisierungsschicht mit der Metallschmelze in Kontakt ist. Dadurch können Störungen im Endprodukt entstehen. Um dies zu vermeiden, ist bei dieser Verfahrensvariante vorgesehen, die Stabilisierungsschicht als Zwischenschicht oder als Außenschicht vorzusehen, die beim Einsatz des Quarzglastiegels mit der Metallschmelze nicht in Kontakt kommt.

Es hat sich außerdem als günstig erwiesen, wenn die Stabilisierungsschicht aus einem Teilchengemisch aus synthetisch erzeugten SiO₂-Teilchen und SiO₂-Teilchen aus natürlich vorkommendem Rohstoff erzeugt wird.

SiO₂-Teilchen aus synthetischem Material sind in der Regel sehr feinteilig und daher für derartige Einschmelzverfahren nicht oder nur nach einer Aufbereitung, wie etwa einer Granulation, uneingeschränkt einsetzbar. Andererseits können gerade die synthetischen SiO₂-Teilchen - auch wegen ihrer geringen Größe - verhältnismäßig leicht mit Defekten der Netzwerkstruktur versehen werden. Bei der erfindungsgemäßen Verfahrensvariante werden daher zur Erzeugung der Stabilisierungsschicht die auch sonst üblichen natürlich vorkommenden SiO₂-Teilchen eingesetzt, die in der Regel keine oder wenige Sauerstoffdefekte aufweisen, und diese Teilchen werden mit synthetischen SiO₂-Teilchen vermischt, die dann wegen ihrer höheren Defektkonzentration eine hohe Beladung des Quarzglases mit chemisch gebundenem Stickstoff ermöglichen. Dabei können die synthetisch erzeugten SiO₂-Teilchen beim Verglasen oder Sintern mit Stickstoff beladen werden, oder auch bereits vorab mit Stickstoff beladen worden sein.

### Ausführungsbeispiel

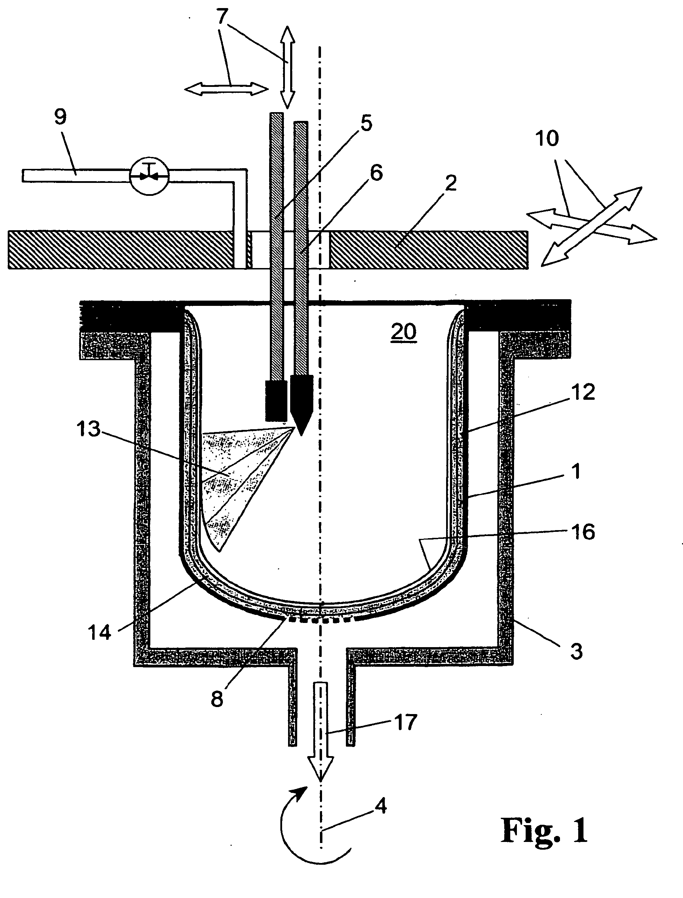

Die Erfindung wird nachfolgend anhand von Ausführungsbeispielen und einer Zeichnung näher erläutert. Als einzige Figur zeigt
- **Figur 1**: in schematischer Darstellung eine Schmelzvorrichtung zur Durchführung des erfindungsgemäßen Verfahrens beim Verfahrensschritt des Vergla- sens der Wandung des Quarzglastiegels.

Die Schmelzvorrichtung gemäß **Figur 1** umfasst eine Schmelzform 1 aus Metall mit einem Innendurchmesser von 75 cm, die mit einem Außenflansch auf einem Träger 3 aufliegt. Der Träger 3 ist um die Mittelachse 4 rotierbar. In den Innenraum 20 der Schmelzform 1 ragen eine Kathode 5 und eine Anode 6 (Elektroden 5; 6) aus Grafit, die - wie anhand der Richtungspfeile 7 angedeutet - innerhalb der Schmelzform 1 in allen Raumrichtungen verfahrbar sind.

Die offene Oberseite der Schmelzform 1 wird von einem Hitzeschild 2 in Form einer wassergekühlten Metallplatte überdeckt, die eine zentrale Durchgangsbohrung aufweist, durch die hindurch die Elektroden 5, 6 in die Schmelzform 1 hineinragen. Der Hitzeschild 2 ist mit einem Gaseinlass 9 für ein Prozessgas versehen. Bei dem Prozessgas handelt es sich entweder um ein Gasgemisch aus 80 Vol.-% Her 20 Vol.-% O₂ oder ein Gasgemisch 60 Vol.-% He / 40 Vol.-% N₂O.

Zwischen der Schmelzform 1 und dem Hitzeschild 2 ist ein Entlüftungsspalt mit einer Weite von 50 mm vorgesehen (Fig. 1 zeigt diese Abmessung und alle anderen Abmessungen der Vorrichtung nur schematisch, nicht maßstäblich). Der Hitzeschild 2 ist in der Ebene oberhalb der Schmelzform 1 horizontal verfahrbar (in x- und y-Richtung), wie dies die Richtungspfeile 10 andeuten.

Der Raum zwischen dem Träger 3 und der Schmelzform 1 ist mittels einer Vakuumeinrichtung, die durch den Richtungspfeil 17 repräsentiert wird, evakuierbar. Die Schmelzform 1 weist eine Vielzahl von Durchlässen 8 auf (diese sind in Figur 1 nur symbolisch im Bodenbereich angedeutet), über die das an der Außenseite der Form 1 anliegende Vakuum 17 nach Innen durchgreifen kann.

Im Folgenden wird die Herstellung eines 28-Zoll-Quarzglastiegels gemäß der Erfindung anhand bevorzugter Ausführungsbeispiele näher erläutert.

### Beispiel 1

In einem ersten Verfahrensschritt wird kristalline Körnung aus natürlichem, mittels Heißchlorierung gereinigtem Quarzsand, mit einer Korngröße im Bereich von 90 µm bis 315 µm in die um ihre Längsachse 4 rotierende Schmelzform 1 eingefüllt. Unter der Wirkung der Zentrifugalkraft und mittels einer Formschablone wird an der Innenwandung der Schmelzform 1 eine rotationssymmetrische tiegelförmige Körnungsschicht 12 aus mechanisch verfestigtem Quarzsand geformt. Die mittlere Schichtdicke der Körnungsschicht 12 beträgt etwa 12 mm.

In einem zweiten Verfahrensschritt wird auf der Innenwandung der Quarzsand-Schicht 12 eine Zwischenkörnungsschicht 14 aus synthetisch hergestelltem und vorab mit Stickstoff dotiertem Quarzglaspulver ebenfalls unter Einsatz einer Formschablone und unter anhaltender Rotation der Schmelzform 1 ausgeformt. Die mittlere Schichtdicke der Zwischenkömungsschicht 14 beträgt ebenfalls etwa 12 mm. Das für die Zwischenkömungsschicht 14 eingesetzte synthetisch erzeugte Quarzglaspulver aus amorphen, sphärischen SiO₂-Teilchen hat Teilchengrößen im Bereich von 80 bis 120 µm, wobei die mittlere Teilchengröße bei etwa 100 µm liegt.

Das Quarzglaspulver wird vorab in einem Nitridierungsverfahren mit Stickstoff beladen. Dabei wird von einem Ausgangspulver ausgegangen, das eine Konzentration an Sauerstoffdefizitstellen von mehr als 2 x 10¹⁵ cm⁻³ aufweist, die herstellungsbedingt - durch Verglasen unter reduzierenden Bedingungen - im Quarzglas des Pulvers enthalten sind. Das so vorgeschädigte Quarzglaspulver wird anschließend bei einer Temperatur von 850 °C in einer Atmosphäre von 20% N₂O Rest Helium, mit Stickstoff beladen. Dabei kommt es zu einer thermischen Zersetzung von N₂O und der Bildung reaktiver Stickstoffatome, die mit den Sauerstoffdefizitstellen unter Bildung von Si-N-Bindungen reagieren. Nach einer Behandlungsdauer von 5 Stunden stellt sich eine Konzentration von 50 Gew.-ppm an chemisch gebundenem Stickstoff ein.

Auf die Zwischenkörnungsschicht 14 wird in einem dritten Verfahrensschritt - ebenfalls unter Einsatz einer Formschablone und unter anhaltender Rotation der Schmelzform 1 - eine weitere SiO₂-Körnungsschicht (16) mit einer mittleren Dicke um 3 mm aus einer "Innenschichtkörnung" ausgeformt, die keine Stickstoff-Beladung und Sauerstoffdefizitstellen unterhalb der Nachweisgrenze aufweist und die ansonsten dem zur Ausbildung der Zwischenschicht eingesetzten Quarzglaspulver entspricht.

In einem weiteren Verfahrensschritt erfolgt das Verglasen der Körnungsschichten 12, 14 und 16. Die Elektroden 5; 6 werden durch die zentrale Öffnung des Hitzeschildes 2 in den Innenraum 20 eingeführt und zwischen den Elektroden 5; 6 ein Lichtbogen gezündet, der in Figur 1 durch die Plasmazone 13 als grau hinterlegter Bereich gekennzeichnet ist. Gleichzeitig wird an der Außenseite der Schmelzform 1 ein Vakuum angelegt, das aber wegen der porösen SiO₂-Körnungsschichten 12, 14; 16 bis in den Innenraum 20 der Schmelzform 1 durchgreift, so dass in diesem Verfahrensstadium kein ausreichend hohes Vakuum erreichbar ist. Dabei wird dem Innenraum 20 über den Gaseinlass 9 ein konstanter und geregelter Prozessgasstrom des Helium-Sauerstoff-Gemischs (80He/20O₂) von 300 l/min zugeführt. Zum Verglasen der Körnungsschichten 12; 14; 16 im Bereich der Seitenwandung werden das Hitzeschild 2 sowie die Elektroden 5; 6 in eine seitliche Position gebracht (wie in Figur 1 dargestellt). Zum Verglasen der Körnungsschichten 12; 14, 16 im Bereich des Bodens wird das Hitzeschild 2 in eine zentrale Position gebracht, wobei die Elektroden 5; 6 ebenfalls in eine zentrale Position gebracht und nach unten abgesenkt werden.

Beim Verglasen bildet sich auf der Innenfläche der inneren Körnungsschicht 16 schnell eine Versiegelungsschicht, die die nicht verschmolzenen Anteile der Tiegelwandung von der Atmosphäre im Schmelzform-Innenraum 20 trennt. Da weiterhin das Gasgemisch aus Helium und Sauerstoff durch die porösen Kömungsschichten 12 und 14 abgepumpt wird, entsteht ein Unterdruck von etwa 200 mbar (absolut). Infolgedessen bildet sich eine dichte, blasenarme und daher transparente Innenschicht. Die dünne, nicht transparente Versiegelungsschicht, die die transparente Innenschicht überzieht, wird im weiteren Prozessverlauf durch die Einwirkung des Plasma 13 zumindest teilweise entfernt und erforderlichenfalls am Ende des Herstellungsprozesses durch Sandstrahlen vollständig beseitigt.

Sobald die verglaste Innenschicht eine Dicke von etwa 2,5 mm erreicht hat, wird die Saugleistung der Vakuumeinrichtung 17 über ein Drosselventil (in Figur 1 nicht dargestellt) so verringert, dass der Druck in den noch nicht verglasten Bereichen der Körnungsschichten 12; 14 auf 900 mbar (Absolutdruck) ansteigt. Das hierzu benötigte Gas kommt insbesondere aus dem Innenraum 20 der Schmelzform 1, aus der es durch nicht verschmolzene Bereiche der Körnungsschichten 12; 14 durch die Durchbrüche 15 der Formwandung austritt. Die Gaszusammensetzung in den nicht verschmolzenen Bereichen der Körnungsschichten 12; 14 kann somit über die Atmosphäre im Innenraum 20 eingestellt werden, bis auch diese Bereiche zu opakem Quarzglas verschmolzen sind. Der Schmelzvorgang wird beendet, bevor die Schmelzfront die Innenwandung der Schmelzform 1 erreicht.

Die innere Oberfläche des so hergestellten Quarzglastiegels wird somit von einer glatten, glasigen und blasenarmen Innenschicht aus synthetischem SiO₂ gebildet, die mit einer Außenschicht aus opakem Quarzglas fest verbunden ist. Etwa die Hälfte der Dicke der Außenschicht wird von dem mit Stickstoff dotierten Quarzglas gebildet, während die Innenschicht frei von Stickstoff ist. Der Quarzglastiegel zeichnet sich durch eine hohe thermische Stabilität und lange Standzeit aus.

### Beispiel 2

In einem ersten Verfahrensschritt wird kristalline Körnung aus natürlichem, mittels Heißchlorierung gereinigtem Quarzsand, mit einer Korngröße im Bereich von 90 µm bis 315 µm in die um ihre Längsachse rotierende Schmelzform eingefüllt. Unter der Wirkung der Zentrifugalkraft und mittels einer Formschablone wird an der Innenwandung der Schmelzform eine rotationssymmetrische tiegelförmige Körnungsschicht aus mechanisch verfestigtem Quarzsand geformt. Die mittlere Schichtdicke der Körnungsschicht beträgt etwa 12 mm.

In einem zweiten Verfahrensschritt wird auf der Innenwandung der Quarzsand-Schicht eine Innenkörnungsschicht aus synthetisch hergestelltem Quarzglaspulver ebenfalls unter Einsatz einer Formschablone und unter anhaltender Rotation der Schmelzform ausgeformt. Die mittlere Schichtdicke der Innenkörnungsschicht beträgt ebenfalls etwa 12 mm.

Das für die Innenkörnungsschicht eingesetzte synthetisch erzeugte Quarzglaspulver aus amorphen, sphärischen SiO₂-Teilchen hat Teilchengrößen im Bereich von 30 bis 150 µm, wobei die mittlere Teilchengröße bei etwa 100 µm liegt. Das Quarzglaspulver hat eine hohe Konzentration an Sauerstoffdefizitstellen von mehr als 2 x 10¹⁵ cm⁻³, die durch Verglasen des Pulvers unter reduzierenden Bedingungen erzeugt worden sind.

In einem weiteren Verfahrensschritt erfolgt das Verglasen der Körnungsschichten, wie oben anhand Beispiel 1 erläutert, wobei im Unterschied dazu dem Innenraum über den Gaseinlass ein konstanter und geregelter Prozessgasstrom des Helium-Distickstoffmonoxid-Gemischs (60He/40N₂O) von 300 l/min zugeführt wird. Dabei kommt es zu einer thermischen Zersetzung von N₂O und der Bildung reaktiver Stickstoffatome, die mit dem Quarzglas und dabei insbesondere mit den Sauerstoffdefizitstellen des Quarzglaspulvers der Innenschicht unter Bildung von Si-N-Bindungen reagieren. Der Gasaustausch der in den Körnungsschichten vorhandenen Atmosphäre durch das von oben einströmende Gas wird durch das Anlegen von Vakuum an der Außenseite der Körnungsschichten unterstützt.

Nach dem Verglasen wird eine Konzentration von 40 Gew.-ppm an chemisch gebundenem Stickstoff in der transparenten Innenschicht ermittelt. Die Innenschicht des so erhaltenen Quarzglastiegels besteht somit aus synthetischem SiO₂, das mit Stickstoff dotiert ist. Sie ist transparent, im Wesentlichen blasenfrei und mit einer Außenschicht aus opakem Quarzglas fest verbunden. Wesentlich ist, dass sie beim bestimmungsgemäßen Einsatz des Quarzglastiegels nicht aufschäumt. Der Quarzglastiegel zeichnet sich durch eine hohe thermische Stabilität und lange Standzeit aus.

## Patentansprüche

1. Verfahren zur Herstellung eines Quarzglastiegels mit einer Tiegelwandung, die mindestens teilweise aus mit Stickstoff dotiertem Quarzglas besteht, indem an einer Innenseite einer Schmelzform (1) eine poröse SiO₂Körnungsschicht (12; 14; 16) aus SiO₂-Teilchen ausgeformt und zu einer Stabilisierungsschicht (14) aus Quarzglas mit darin chemisch gebundenem Stickstoff verglast wird, wobei die SiO₂-Teilchen vor oder während des Verglasens unter Einsatz eines Stickstoff enthaltenden Reaktionsgases nitridiert werden, **dadurch gekennzeichnet, dass** als stickstoffhaltiges Reaktionsgas ein Stickoxid eingesetzt wird.

2. Verfahren nach Anspruch 1, **dadurch gekennzeichnet, dass** als stickstoffhaltiges Reaktionsgas Distickstoffmonoxid eingesetzt wird.

3. Verfahren nach einem der vorhergehenden Ansprüche, **dadurch gekennzeichnet, dass** SiO₂-Teilchen eingesetzt werden, die vor dem Nitridieren eine Konzentration an Sauerstoffmangeldefekten von mindestens 2 x 10¹⁵ cm⁻³, vorzugsweise mindestens 1 x 10¹⁶ cm⁻³, aufweisen.

4. Verfahren nach Anspruch 3, **dadurch gekennzeichnet, dass** die Sauerstoffmangeldefekte durch eine Temperaturbehandlung der SiO₂-Teilchen bei einer Temperatur oberhalb von 500 °C in reduzierend wirkender Atmosphäre eingestellt werden.

5. Verfahren nach einem der vorhergehenden Ansprüche, **dadurch gekennzeichnet, dass** SiO₂-Teilchen eingesetzt werden, die eine mittlere Teilchengröße im Bereich von 30 µm bis 300 µm aufweisen (D₅₀-Wert).

6. Verfahren nach einem der vorhergehenden Verfahrensansprüche, **dadurch gekennzeichnet, dass** SiO₂-Teilchen eingesetzt werden, die vor der Ausformung der porösen SiO₂-Schicht nitridiert werden.

7. Verfahren nach einem der vorhergehenden Ansprüche, **dadurch gekennzeichnet, dass** die Nitridierung bei einer Behandlungstemperatur unterhalb von 1.100 °C, vorzugsweise im Temperaturbereich zwischen 650 und 1.000 °C erfolgt.

8. Verfahren nach einem der vorhergehenden Ansprüche, **dadurch gekennzeichnet, dass** der Stickoxidgehalt der Atmosphäre während der Nitridierung mindestens zeitweise zwischen 2 und 50 Vol.-%, vorzugsweise zwischen 5 und 20 Vol.-%, beträgt.

9. Verfahren nach einem der Ansprüche 6 bis 8, **dadurch gekennzeichnet, dass** die Nitridierung unter einem Überdruck des Stickstoff enthaltenden Reaktionsgases erfolgt.

10. Verfahren nach einem der vorhergehenden Ansprüche, **dadurch gekennzeichnet, dass** eine Stabilisierungsschicht (14) mit einer Dicke im Bereich von 1 bis 30 mm, vorzugsweise mit einer Dicke im Bereich von 2 bis 15 mm, erzeugt wird.

11. Verfahren nach einem der vorhergehenden Ansprüche, **dadurch gekennzeichnet, dass** die Stabilisierungsschicht (14) in einem Bereich der Tiegelwandung (1) erzeugt wird, der beim bestimmungsgemäßen Einsatz mit einer im Tiegel enthaltenen Schmelze nicht in Kontakt kommt.

12. Verfahren nach einem der vorhergehenden Ansprüche, **dadurch gekennzeichnet, dass** die Stabilisierungsschicht (14) aus einem Teilchengemisch aus synthetisch erzeugten SiO₂-Teilchen und SiO₂-Teilchen aus natürlich vorkommendem Rohstoff erzeugt wird.

## Claims

1. A method for producing a quartz glass crucible having a crucible wall consisting at least in part of nitrogen-doped quartz glass, in that on an inside of a melt mold (1) a porous SiO₂ grain layer (12; 14; 16) of SiO₂ particles is formed and vitrified into a stabilization layer (14) of quartz glass with nitrogen chemically bound therein, the SiO₂ particles being nitrided prior to or during vitrification using a nitrogen-containing reaction gas, **characterized in that** nitrogen oxide is used as the nitrogen-containing reaction gas.

2. The method according to claim 1, **characterized in that** nitrous oxide is used as the nitrogen-containing reaction gas.

3. The method according to any one of the preceding claims, **characterized in that** SiO₂ particles are used that prior to nitriding exhibit a concentration of oxygen deficiency defects of at least 2 x 10¹⁵ cm⁻³, preferably at least 1 x 10¹⁶ cm⁻³.

4. The method according to claim 3, **characterized in that** the oxygen deficiency defects are set by temperature treatment of the SiO₂ particles at a temperature above 500° in an atmosphere having a reducing effect.

5. The method according to any one of the preceding claims, **characterized in that** SiO₂ particles are used having a mean particle size in the range of from 30 µm to 300 µm (D₅₀ value).

6. The method according to any one of the preceding claims, **characterized in that** SiO₂ particles are used that are nitrided prior to the shaping of the porous SiO₂ layer.

7. The method according to any one of the preceding claims, **characterized in that** nitriding is carried out at a treatment temperature below 1,100°C, preferably in the temperature range between 650°C and 1,000°C.

8. The method according to any one of the preceding claims, **characterized in that** the nitrogen oxide content of the atmosphere during nitriding is at least temporarily between 2 and 50 vol. %, preferably between 5 and 20 vol. %.

9. The method according to any one of claims 6 to 8, **characterized in that** nitriding is carried out at an overpressure of the nitrogen-containing reaction gas.

10. The method according to any one of the preceding claims, **characterized in that** a stabilization layer (14) is formed with a thickness ranging from 1 mm to 30 mm, preferably with a thickness ranging from 2 mm to 15 mm.

11. The method according to any one of the preceding claims, **characterized in that** the stabilization layer (14) is formed in an area of the crucible wall (1) that during the intended use does not get into contact with a melt contained in the crucible.

12. The method according to any one of the preceding claims, **characterized in that** the stabilization layer (14) is formed from a particle mixture of synthetically produced SiO₂ particles and SiO₂ particles of naturally occurring raw material.

## Revendications

1. Procédé pour la fabrication d'un creuset en verre de quartz avec une paroi de creuset qui se compose au moins partiellement de verre de quartz dopé d'azote dans le fait que sur une face interne d'un moule de fusion (1) une couche granulée poreuse SiO₂ (12; 14; 16) est formée à partir de particules SiO₂ et vitrifiée en une couche de stabilisation (14) en verre de quartz avec de l'azote lié chimiquement, les particules SiO₂ étant nitrifiées avant et après la vitrification en utilisant un gaz de réaction contenant de l'azote, **caractérisé en ce qu'**il est utilisé en tant que gaz de réaction contenant de l'azote un oxyde d'azote.

2. Procédé selon la revendication 1, **caractérisé en ce qu'**il est utilisé en tant que gaz de réaction contenant de l'azote un monoxyde diazoté.

3. Procédé selon l'une des revendications précédentes, **caractérisé en ce que** des particules de SiO₂ sont utilisées lesquelles présentent avant la nitrification une concentration de défauts de manque d'oxygène d'au moins 2 x 10¹⁵ cm⁻³, de préférence au moins 1 x 10¹⁶cm⁻³.

4. Procédé selon la revendication 3, **caractérisé en ce que** les défauts de manque d'oxygène sont paramétrés par un traitement thermique des particules SiO₂ à une température supérieure à 500°C dans une atmosphère réductrice.

5. Procédé selon l'une des revendications précédentes, **caractérisé en ce que** des particules de SiO₂ sont utilisées lesquelles présentent une grandeur moyenne de particule comprise entre 30 µm et 300 µm (valeur D₅₀).

6. Procédé selon l'une des revendications précédentes, **caractérisé en ce que** des particules de SiO₂ sont utilisées lesquelles sont nitrifiées avant la formation de la couche SiO₂ poreuse.

7. Procédé selon l'une des revendications précédentes, **caractérisé en ce que** la nitrification s'effectue à une température de traitement inférieure à 1100°C de préférence à une température comprise entre 650 et 1000°C.

8. Procédé selon l'une des revendications précédentes, **caractérisé en ce que** la teneur en oxyde d'azote de l'atmosphère pendant la nitrification est au moins comprise entre 2 et 50 pour cent en volume, de préférence entre 5 et 20 pour cent en volume.

9. Procédé selon l'une des revendications 6 à 8, **caractérisé en ce que** la nitrification s'effectue sous une dépression du gaz de réaction contenant de l'azote.

10. Procédé selon l'une des revendications précédentes, **caractérisé en ce qu'**une couche de stabilisation (14) est générée avec une épaisseur comprise entre 2 et 15 mm.

11. Procédé selon l'une des revendications précédentes, **caractérisé en ce que** la couche de stabilisation (14) est générée dans une épaisseur de paroi (1) qui ne vient pas en contact avec une fusion se trouvant dans le creuset lors d'une utilisation conforme à la destination.

12. Procédé selon l'une des revendications précédentes, **caractérisé en ce que** la couche de stabilisation (14) est générée à partir d'un mélange de particules SiO₂ produites synthétiquement et de particules SiO₂ d'origine naturelle.
